# EUROPEAN PATENT APPLICATION

(11) **EP 2 315 361 A1**
(43) Date of publication of application: **27.04.2011**
(21) Application number: 09802433.4
(22) Date of filing: 31.07.2009
(51) Int. Cl.: H03M 13/29

(54) **METHOD AND DEVICE FOR PUNCTURING TURBO CODED BIT STREAM**

(30) Priority: 31.07.2008 CN 200810144065
(71) Applicant: Huawei Technologies Co., Ltd., Longgang District, Shenzhen Guangdong 518129 (CN)
(72) Inventor: WU, Dewen, 518129 Shenzhen (CN); MEI, Jingjin, 518129 Shenzhen (CN); TAN, Bin, 518129 Shenzhen (CN)
(74) Representative: Kreuz, Georg Maria
(86) International application number: PCT/CN2009/073012
(87) International publication number: WO 2010/012240

(57) **Abstract**

A method for puncturing the Turbo-coded bit stream, applicable to the scenario in which the code rate is 1 for Turbo coding and puncturing, is disclosed. The method includes: puncturing a bit stream Turbo-coded with a code rate of 1/N, where the N is a positive integer, and during the puncturing, at least one bit in each bit combination is reserved, each bit combination contains a system bit and check bits related to the system bit, system bits in different bit combinations are different, and each system bit of all the system bits belongs to a different bit combination; and outputting all reserved bits. A device for puncturing the Turbo-coded bit stream is provided herein.

## Description

This application claims priority to Chinese Patent Application No. 200810144065.8, filed with the Chinese Patent Office on July 31, 2008 and entitled with "METHOD AND DEVICE FOR PUNCTURING TURBO-CODED BIT STREAM", which is incorporated herein by reference in its entirety.

### FIELD OF THE INVENTION

This invention relates to the field of encoding technology, and in particular, to a technology of puncturing a Turbo-coded bit stream.

### BACKGROUND OF THE INVENTION

The main process of wireless data transmission at the transmitting end includes: (1) digitalization and source coding; (2) channel coding; (3) interleaving; (4) burst formatting (shaping filter); (5) encryption; and (6) modulation.

For all encoding services of the Enhanced General Packet Radio Service 2 (EGPRS2) service, such as Reduced Symbol Duration, Higher Order Modulation and Turbo Coding (REDHOT), the Turbo coding mode is adopted for channel codes. In practice, after being Turbo-coded, the bit stream is punctured.

Take REDHOT B modulation and coding-12 with Piggyback ACK/NACK (PAN) as an example, and assume that the Turbo code rate is 1/3, and the code rate for Turbo coding and puncturing is 1. The Turbo coding and puncturing process includes: inputting a bit stream of K bits; performing Turbo coding with 1/3 code rate on the bit stream of K bits; outputting a bit stream of 3K + 12 bits after Turbo coding, where the 3K + 12 bits include 12 tail bits; puncturing the bit stream of 3K + 12 bits after Turbo coding; and outputting a bit stream of K bits, where the K bits output after puncturing include three tail bits.

In the preceding conventional art, the K bits output in the last include three tail bits. To ensure that the code rate is 1, in addition to puncturing the first and second check bits related to the system bits, three system bits are certainly punctured during puncturing, where the system bits refer to useful bits, that is, the input K bits said above. Therefore, for coding services with the code rate of 1, decoding cannot be implemented correctly without noise, and independent decoding is unavailable for a single transmission.

### SUMMARY OF THE INVENTION

Embodiments of the present invention provide a method and device for puncturing a Turbo-coded bit stream to ensure correct decoding without noise and implement independent decoding for a single transmission.

An embodiment of the present invention provides a method for puncturing a Turbo-coded bit stream. This method is applicable to the scenario in which the code rate equals 1 for Turbo coding and puncturing. The method includes:
puncturing a bit stream Turbo-coded with a code rate of 1/N, wherein the N is a positive integer, and during the puncturing, at least one bit in each bit combination is reserved, each bit combination contains a system bit and check bits related to the system bit, system bits in different bit combinations are different, and each system bit of all the system bits belongs to a different bit combination;
outputting all reserved bits.

An embodiment of the present invention provides a device for puncturing the Turbo-coded bit stream. This device is applicable to the scenario in which the code rate equals 1 for Turbo coding and puncturing. The device includes:
a puncturing unit, adapted to: puncture a bit stream Turbo-coded with a code rate of 1/N, wherein the N is a positive integer, and during the puncturing, at least one bit in each bit combination is reserved, each bit combination contains a system bit and check bits related to the system bit, system bits in different bit combinations are different, and each system bit of all the system bits belongs to a different bit combination; and
a bit outputting unit, adapted to output all bits reserved by the puncturing unit.

During puncturing, at least one bit in each bit combination is reserved. In this case, the decoding end can correctly obtain all system bits by decoding based on the system bits or the check bits corresponding to the system bits. This ensures correct decoding without noise and implements independent decoding for a single transmission for coding services with the code rate of 1 during Turbo coding and puncturing.

### BRIEF DESCRIPTION OF THE DRAWINGS

FIG. 1 is a flowchart of the method for puncturing the Turbo-coded bit stream according to an embodiment of the present invention;
FIG. 2 is a flowchart of the device for puncturing the Turbo-coded bit stream according to an embodiment of the present invention; and
FIG. 3 shows a schematic view of Turbo coding and puncturing for EGPRS 2 DBS-12 with PAN according to an embodiment of the present invention.

### DETAILED DESCRIPTION OF THE EMBODIMENTS

The purpose, technical solution, and advantages of embodiments of the present invention are hereinafter described in detail with reference to the accompanying drawings.

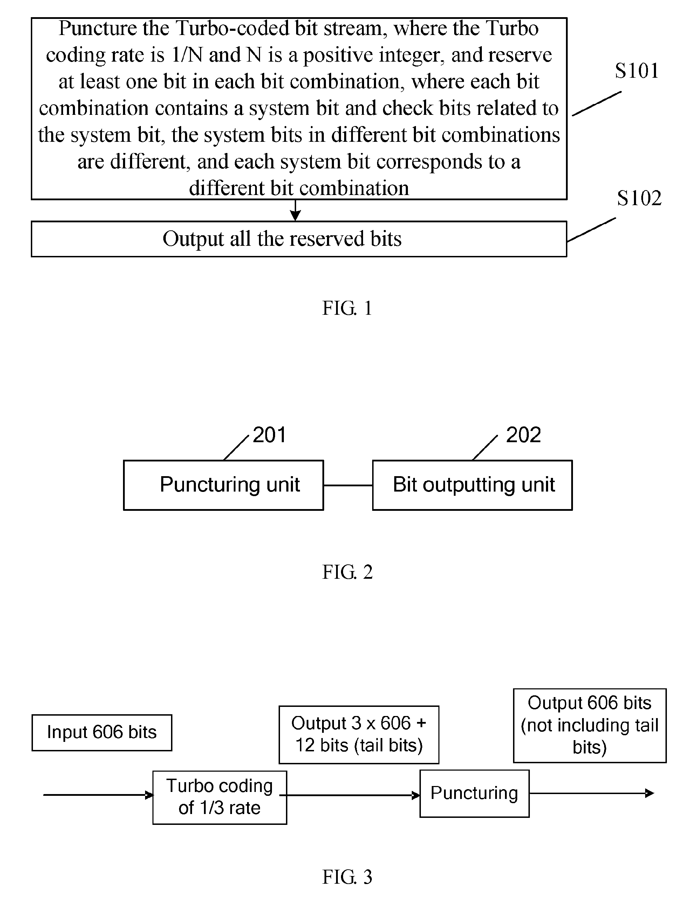

A method for puncturing the Turbo-coded bit stream is provided in an embodiment of the present invention. The method is applicable to the scenario in which the code rate is 1 for Turbo coding and puncturing. As shown in FIG. 1, the method includes:
Step S101: The bit stream Turbo coded with 1/N code rate is punctured, N being a positive integer, during the puncturing, at least one bit in each bit combination is reserved, and the bit combination contains a system bit and check bits related to the system bit. The system bits in all bit combinations are different, and each system bit of all the system bits belongs to each different bit combination.

Before the puncturing operation, the Turbo coder performs Turbo coding with 1/N code rate on the input bit stream. Take EGPRS2 DBS-12 as an example. It is assumed that the input bit stream contains K bits. After performing Turbo coding with 1/3 code rate on the bit stream of K bits, the Turbo coder outputs the Turbo-coded bit stream of 3K + 12 bits, among which the last 12 bits are tail bits.

In actual implementation, many ways can be used to reserve at least one bit in each bit combination to ensure independent decoding for a single transmission after the bit stream is punctured.

For example, the system bit in each bit combination can be reserved. The bits identified by the bit location number k that meets the requirement of *k%N* == 0 can be reserved, where k in *k%N* == 0 is the bit location number of a non-tail bit and can be exactly divided by *N*, and *N* is the same as that in the 1/N code rate.

Alternatively, at least one check bit in each bit combination can be reserved. For example, the bits identified by the location number *k* that meets the requirement of *k%N* == *R* can be reserved, where *k* in *k%N* == *R* is the bit location number of a non-tail bit that can not be exactly divided by N but with a remainder R, *N* being the same as that in the 1/N rate, and *R* being a positive integer that is not greater than *N*-1.

In another example, the system bit in each bit combination among certain bit combinations is reserved and at least one check bit in each bit combination among the remaining bit combinations is reserved. It is assumed that there are 606 system bits in total. After Turbo coding with 1/3 code rate is performed, there are 3 x 606 + 12 bits, among which the last 12 bits are tail bits. During puncturing, 300 system bits and the first or second check bits corresponding to the remaining 306 system bits can be reserved, and the last 12 tail bits are deleted.

Step S102: All reserved bits are output.

The number of output bits that contain at least one bit in each bit combination is the same as the number of bits in the bit stream before Turbo coding with 1/N rate. In this case, if at least one bit in each bit combination is output, and tail bits are to be output, the number of output bits would be greater than the number of bits in the bit stream before Turbo coding with 1/N rate. To solve this, all tail bits are deleted to ensure that the number of output bits that contain at least one bit in each bit combination is the same as the number of bits in the bit stream before Turbo coding with 1/N rate.

During the puncturing operation according to embodiments of the present invention, at least one bit in each bit combination is reserved. In this case, all system bits can be correctly decoded by the decoding end based on the system bits or the check bits corresponding to the system bits. This ensures correct decoding without noise and implements independent decoding for a single transmission for coding services with the code rate of 1 for Turbo coding and puncturing.

In addition, all tail bits can be deleted during the puncturing operation according to embodiments of the present invention. This ensures that the number of output bits that comprise at least one bit in each bit combination is the same as the number of bits in the bit stream before Turbo coding with 1/N code rate.

The preceding method can be implemented using different devices. FIG. 2 shows a device for puncturing the Turbo-coded bit stream. The device is applicable to the scenario in which the code rate is 1 for Turbo coding and puncturing. The device includes: a puncturing unit 201, adapted to puncture the bit stream Turbo-coded with a code rate of 1/N and N is a positive integer, where at least one bit in each bit combination is reserved, each bit combination contains a system bit and check bits related to the system bit, the system bits in different bit combinations are different, and each system bit of all the system bits belongs to a different bit combination; and a bit outputting unit 202, adapted to output all reserved bits.

In actual implementation, the puncturing unit 201 can reserve at least one bit in each bit combination in many ways to ensure independent decoding for a single transmission after the bit stream is punctured.

For example, the puncturing unit 201 can reserve the system bit in each bit combination. The detailed implementation is: The puncturing unit 201 reserves the bits identified by the bit location number k that meets the requirement of *k%N* == 0, where k in *k%N* == 0 is the bit location number of a non-tail bit and can be exactly divided by N, and N is the same as that in the 1/N rate.

Alternatively, the puncturing unit 201 can reserve at least one check bit in each bit combination. The detailed implementation is: The puncturing unit 201 reserves the bits identified by the location number k that meets the requirement of *k%N* == *R*, where k in *k%N == R* is the bit location number of a non-tail bit that can not be exactly divided by N but with a remainder R, N being the same as that in the 1/N rate, and R being a positive integer that is not greater than N-1.

Another example is that the puncturing unit 201 can reserve the system bit in each bit combination among certain bit combinations and at least one check bit in each bit combination among the remaining bit combinations. Assume that there are a total of 606 system bits. After Turbo coding with 1/3 code rate, there are 3 × 606 + 12 system bits, among which the last 12 bits are tail bits. During puncturing, 300 system bits and the first or second check bits corresponding to the remaining 306 system bits can be reserved, and the last 12 tail bits are deleted.

Since the number of bits output by the bit outputting unit 203, which includes at least one bit in each bit combination, is the same as the number of bits in the bit stream before Turbo coding with 1/N code rate. In this case, if at least one bit in each bit combination is output, and tail bits are to be output, the number of output bits would be greater than the number of bits in the bit stream before Turbo coding with 1/N rate. To solve this, all tail bits can be deleted to ensure that the number of output bits that comprise at least one bit in each bit combination is the same as the number of bits in the bit stream before Turbo coding with 1/N code rate.

During the puncturing operation according to embodiments of the present invention, at least one bit in each bit combination is reserved. In this case, the decoding end can correctly decode and obtain all system bits based on the system bits or the check bits corresponding to the system bits. This ensures correct decoding without noise and implements independent decoding for a single transmission for coding services with the code rate of 1 during Turbo coding and puncturing.

In addition, all tail bits can be deleted during the puncturing operation according to embodiments of the present invention. This ensures that the number of output bits that comprise at least one bit in each bit combination is the same as the number of bits in the bit stream before Turbo coding with 1/N rate.

To enable those skilled in the art to better understand the embodiments of the present invention, the following takes EGPRS2 DBS-12 with PAN as an example to describe the method for puncturing the Turbo-coded bit stream provided in an embodiment of the present invention.

As shown in FIG. 3, after the input 606 bits are Turbo-coded with 1/3 code rate, 3 x 606 + 12 bits are output. Among the output bits, the last 12 bits are tail bits. The sequence of the bits is as follows:
*a*₀*a*₁*a*₂*a*₃*a*₄*a*₅......*a*₃*ᵢa*_{3*i*+1}*a*_{3*i*+2}......*a*₁₈₁₅*a*₁₈₁₆*a*₁₈₁₇*a*₁₈₁₈*a*₁₈₁₉*a*₁₈₂₀*a*₁₈₂₁*a*₁₈₂₂*a*₁₈₂₃*a*₁₈₂₄*a*₁₈₂₅*a*₁₈₂₆*a*₁₈₂₇*a*₁₈₂₈*a*₁₈₂₉

The 3 x 606 + 12 bits are punctured by using any one of the following modes:

### 1. P1 puncturing mode

Only the bits identified by the bit location number k that meets the requirement of *k*%3 == 0, where 0 ≤ *k* ≤ 1817. That is, only the 606 system bits are transmitted, and the 12 tail bits are deleted.

### 2. P2 puncturing mode

Only the bits identified by the bit location number k that meets the requirement of *k*%3 ==1, where 0 ≤ *k* ≤ 1817. That is, only the 606 first check bits are transmitted, and the 12 tail bits are deleted.

### 3. P3 puncturing mode

Only the bits identified by the bit location number k that meets the requirement of *k*%3 == 2 , where 0 ≤ *k* ≤ 1817. That is, only the 606 second check bits are transmitted, and the 12 tail bits are deleted.

Table 1 lists the data before and after the puncturing.

**Table 1**

| | **Number of Bits Input by the Turbo Coder** | **Number of Bits Output by the Turbo** | **Number of Punctured Bits** | **Number of Bits After Puncturing** | **Code rate** |
|---|---|---|---|---|---|
| DBS12with PAN | 606 | 1830 | 1224 | 606 | 606/606 = 1 |

As shown in Table 1, for the 606 bits that are input before Turbo coding with 1/3 code rate and the 606 bits that are output after puncturing, the code rate is 1. All system bits or check bits related to the system bits are reserved, thus ensuring the self-decoding capability.

It is understandable to those skilled in the art that the present invention can be implemented by the software and necessary hardware platform or completely by the hardware. In many situations, however, the former implementation is better. All or certain contributions made by the technical solution provided in the present invention to the background technology can be performed by software. The software may be stored in a storage medium such as ROM/RAM, magnetic disk, and compact disk. The software includes several instructions used to instruct a computer (a personal computer, server, or network device) to implement methods provided in all embodiments or certain parts of the embodiments provided in the present invention.

Details above are only a preferable method of the present invention. It is apparent that those skilled in the art can make various modifications and variations to the invention without departing from the spirit and scope of the invention. The invention is intended to cover the modifications and variations provided that they fall in the scope of protection defined by the following claims or their equivalents.

## Claims

1. A method for puncturing a Turbo-coded bit stream, applicable to a scenario in which a code rate for Turbo coding and puncturing equals 1, comprising:
puncturing a bit stream Turbo-coded with a code rate of 1/N, wherein the N is a positive integer, and during the puncturing, at least one bit in each bit combination is reserved, each bit combination contains a system bit and check bits related to the system bit, system bits in different bit combinations are different, and each system bit of all the system bits belongs to a different bit combination;
outputting all reserved bits.

2. The method for puncturing the Turbo-coded bit stream according to claim 1, wherein the at least one bit in each bit combination is reserved further comprises that: a system bit in each bit combination is reserved.

3. The method of puncturing the Turbo-coded bit stream according to claim 2, wherein the a system bit in each bit combination is reserved further comprises: a bit identified by bit location number *k* that can be exactly divided by *N* is reserved.

4. The method for puncturing the Turbo-coded bit stream according to claim 1, wherein the at least one bit in each bit combination is reserved further comprises:
at least one check bit in each bit combination is reserved.

5. The method of puncturing the Turbo-coded bit stream according to claim 4, wherein the at least one check bit in each bit combination is reserved further comprises:
a bit identified by bit location number *k* that can not be exactly divided by N but with a remainder R is reserved, *R* being a positive integer that is not greater than *N*-1.

6. The method for puncturing the Turbo-coded bit stream according to claim 1, wherein the at least one bit in each bit combination is reserved further comprises:
a system bit in each bit combination among certain bit combinations and at least one check bit in each bit combination among remaining bit combinations is reserved.

7. The method for puncturing the Turbo-coded bit stream according to claim 1, wherein, if the code rate 1/N equals 1/3, the all reserved bits outputted are bits consisting of one bit in each bit combination of 606 bit combinations.

8. The method for puncturing the Turbo-coded bit stream according to any one of claims 1-7, wherein:
all tail bits are punctured when at least one bit in each bit combination is reserved.

9. A device for puncturing a Turbo-coded bit stream, applicable to a scenario in which a code rate for Turbo coding and puncturing equals 1, comprising:
a puncturing unit, adapted to: puncture a bit stream Turbo-coded with a code rate of 1/N, wherein the N is a positive integer, and during the puncturing, at least one bit in each bit combination is reserved, each bit combination contains a system bit and check bits related to the system bit, system bits in different bit combinations are different, and each system bit of all the system bits belongs to a different bit combination; and
a bit outputting unit, adapted to output all bits reserved by the puncturing unit.

10. The device for puncturing the Turbo-coded bit stream according to claim 9, wherein the puncturing unit is further adapted to: delete all tail bits when reserving the at least one bit in each bit combination.

11. The device for puncturing the Turbo-coded bit stream according to claim 9, wherein the puncturing unit is adapted to reserve the system bit in each bit combination.

12. The device for puncturing the Turbo-coded bit stream according to claim 11, wherein the puncturing unit is adapted to reserve a bit identified by the bit location number *k* that can be exactly divided by *N*.

13. The device for puncturing the Turbo-coded bit stream according to claim 9, wherein the puncturing unit is adapted to reserve at least one check bit in each bit combination.

14. The device for puncturing the Turbo-coded bit stream according to claim 13, wherein the puncturing unit is adapted to reserve a bit identified by the bit location number *k* that can not be exactly divided by N but with a remainder R, *R* being a positive integer that is not greater than *N*-1.

15. The device for puncturing the Turbo-coded bit stream according to claim 9, wherein the puncturing unit is adapted to reserve a system bit in each bit combination among certain bit combinations and at least one check bit in each bit combination among remaining bit combinations.
